Europäisches Patentamt

(19) European Patent Office

Office européen des brevets

(11) Publication number: **0 049 972**
**A2**

(12) # EUROPEAN PATENT APPLICATION

(21) Application number: **81304491.4**

(22) Date of filing: **29.09.81**

(51) Int. Cl.³: **H 03 H 15/02**

(30) Priority: **14.10.80 US 196401**

(43) Date of publication of application:
**21.04.82 Bulletin 82/16**

(84) Designated Contracting States:
**DE FR GB IT**

(71) Applicant: **MOTOROLA, INC.**
**Corporate Offices, Motorola Center 1303 East Algonquin Rd.**
**Schaumburg Illinois 60196(US)**

(72) Inventor: **Huntington, Robert C.**
**5924 Calle del Sud**
**Phoenix Arizona 85018(US)**

(74) Representative: **Newens, Leonard Eric et al,**
**F.J. CLEVELAND CO. 40/43 Chancery Lane**
**London WC2A 1JQ(GB)**

(54) Coefficient weighting for CTD transversal filters.

㊼ Coefficient weighting in split electrode, Charge Transfer Devices (CTD's) is improved by connecting only the signal bearing segment (16, 19) of each sense electrode to a sense bus. The remaining segment (17, 18) is connected to a neutral bus (C).

FIG 1

## DESCRIPTION

### BACKGROUND

This invention relates to Charge Transfer Devices (CTD's) and, in particular, to split electrode CTD's having an improved weighting.

Largely due to advances in large scale integrated circuit technology in the last decade, digital filters have increasingly replaced their analogue predecessors in a variety of applications. Among the several kinds of transversal filters are what are known as CTD's, a term used to encompass both charge coupled devices and bucket brigade devices.

The operation of a CTD filter can be summarized as follows. An input analog signal is sampled periodically and each sample is linearly converted to a corresponding charge. These charges are propagated down the CTD in the same manner as in a shift register. At each of the N successive sensing storage sites, the associated charge is multiplied by a weighting coefficient and all of these N products are summed to provide the instantaneous output of the filter. The weighting coefficients represent the impulse response in the time domain which is Fourier transform related to the desired filter response in the frequency domain.

In prior art CTD filters, a normalized coefficient $h$ is realized by locating a split in a sensing electrode such that the lengths of the two segments are in the ratio $(1+h):(1-h)$. If the charge density beneath an electrode is uniform across the channel, the charge induced in each segment is proportional to the segment length. The segments are connected one each to first and second busses wherein the induced charges from each segment are summed. The busses are connected, respectively, to the inverting and non-inverting inputs of a sense amplifier. The sense amplifier generates an output signal proportional to the difference between the sums of the charges on the first and second busses. Since only the difference in charge contributes to the output signal, much of the electrode area contributes nothing to the output signal from the sense amplifier but provides a substantial capacitive load on the bus. Further, this configuration requires that the sense amplifiers detect a small charge difference between two large charges on the busses.

An improvement on the split electrode CTD is outlined in U.S. Patent 4,086,609. As noted therein, a doubly split electrode is used to reduce the area of source of the sense electrode segments, although neither the weighting function nor the positioning of the splits is described.

Since any reduction in the electrode area attached to the busses will decrease the capacitive load, it is desirable to reduce unnecessary electrode area. However, reducing electrode area reduces the charge applied to the bus. Thus it is desirable to enlarge as much as possible the ratio of that portion of the electrode contributing differential mode signal to that portion contributing only common mode signal. Further, eliminating electrode portions providing complementary charge to the busses reduces "common mode" signals to the sense amplifier, reduces noise, and makes less stringent requirements of the sense amplifier.

The problem, then, is to resolve these conflicting desiderata in a split electrode configuration implementing a given weighting function.

In view of the foregoing, it is therefore an object of the present invention to provide an improved split electrode CTD filter.

Another object of the present invention is to provide an improved split electrode structure having reduced common mode signal to the sensing circuit.

A further object of the present invention is to provide a CTD filter having improved harmonic distortion and reduced noise.

Another object of the present invention is to provide an improved CTD filter of relatively simple construction.

## SUMMARY

The foregoing objects are achieved in the present invention wherein a pair of sense busses are provided. The electrodes are split proportional to $\underline{h}$, a normalized weighting function, with the signal bearing segment connected to one bus if the coefficient is positive and to the other bus if the coefficient is negative. The other portions of the electrodes are connected to a neutral bus which is not connected to the sensing circuitry. In a preferred embodiment, the neutral bus comprises two electrically connected, conductive runs on both sides of the channel area, thereby simplifying the connections to the portions of each electrode which are not to contribute to the output signal.

## DETAILED DESCRIPTION

A more complete understanding of the present invention can be obtained by considering the following detailed description in conjunction with the accompanying drawings, in which:

FIGURE 1 is a top plan view of a portion of a CTD in accordance with the present invention.

FIGURE 2 is a cross-section of a portion of a CTD in accordance with the present invention.

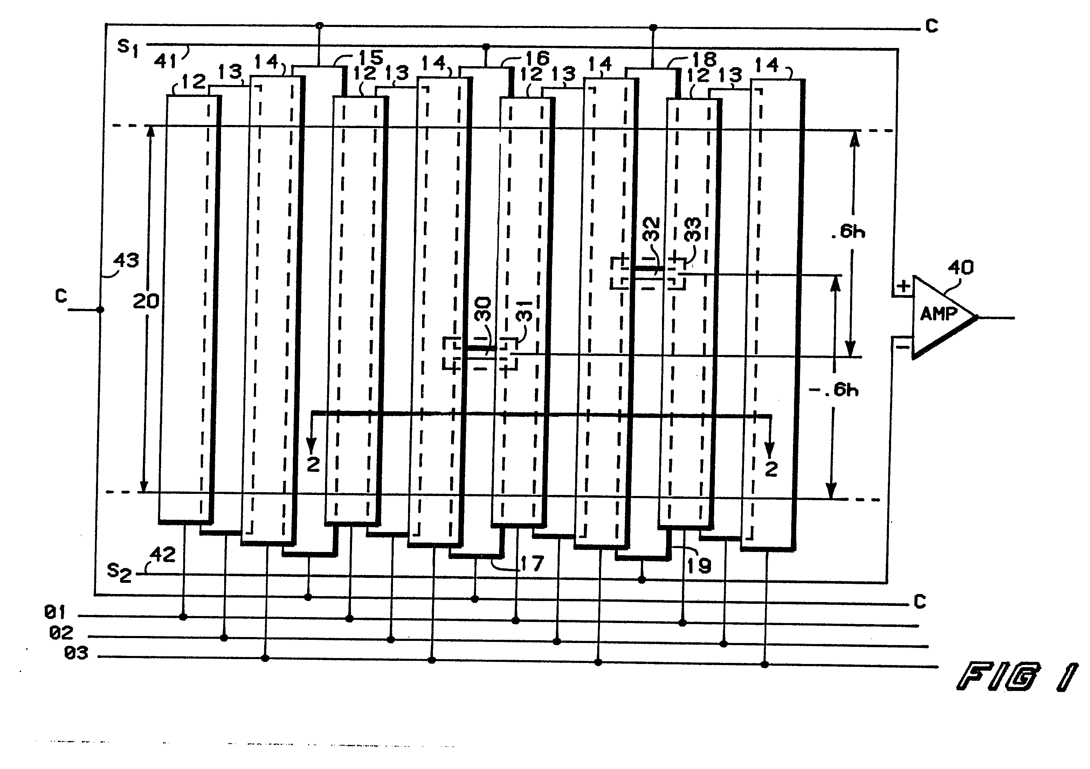

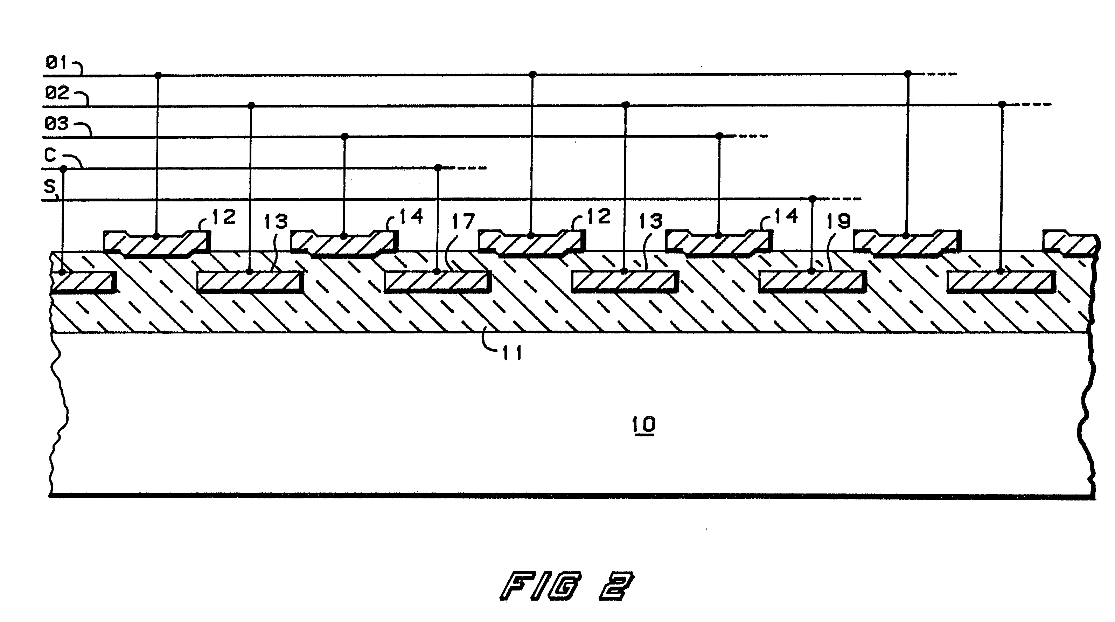

FIGURES 1 and 2 illustrate a preferred embodiment of the present invention in which a plurality of charge transfer electrodes are formed in an insulating layer overlying a semiconductive substrate. Specifically, with reference to either FIGURE 1 or 2, wherein like elements bear the same reference numeral, semiconductor substrate 10, which preferably comprises silicon, has formed thereover a variable thickness insulating layer 11, preferably comprising silicon dioxide. Disposed within, or on, insulating layer 11 are a plurality of overlapping electrodes 12-19, preferably comprising polycrystalline silicon. Specifically, storage electrodes 13, 15, 16, 17, 18, and 19 are disposed in proximity to substrate 10, while transfer electrodes 12 and 14 are positioned slightly further away from substrate 10 and overlap, but do not contact, adjacent storage electrodes. The construction of charge transfer devices in accordance with the present invention may be accomplished utilizing techniques well-known per se to those of skill in the art.

It is desired that locations of all splits relative to channel edges be fixed by a single mask in order to avoid distortion of coefficients resulting from misalignment of one mask relative to another (i.e., first polysilicon mask relative to active area mask). Typically this is accomplished by locating the split in the first polysilicon gate on top of a field oxide island such that the island edges constitute the effective edges of the split. Because the channel stop also is defined by field oxide, the single active area mask locates both the splits and the channel.

As illustrated in FIGURE 1, the plurality of transfer and storage electrodes define a channel area having a width 20. Unlike prior art system wherein the weighting function is obtained by splitting the sense electrode into two segments having lengths proportional to (1+h) and (1-h), in accordance with the present invention the split is located proportional to $\underline{h}$ as indicated in FIGURE 1. The balance of the electrode, which does not contribute to the output signal, is connected to neutral bus 43. In the examples illustrated in FIGURE 1, split 30 is formed over a field oxide region 31 and split 32 is formed over field oxide region 33. Split 30 separates segments 16 and 17 while split 32 separates segments 18 and 19. Segment 16 is proportional to +0.6 while segment 19 is proportional to -0.6. Segment 16 is connected to sense line 41 which is connected to the non-inverting input of sense amplifier 40 while sense segment 19 is connected to line 42, which in turn is connected to the inverting input of sense amplifier 40. Segments 17 and 18 do not contribute to the output signal since they are connected to neutral bus 43, which is not connected to sense amplifier 40. As understood by those of skill in the art the number and location of the splits is determined by the impulse response in the time domain desired from the CTD.

There are process limitations which cause difficulty for the case of very small, but non-zero, coefficients. For these coefficients, the split should be located near either edge of channel 20. However, the disparate thicknesses of the gate and field oxides, e.g. 800Å $(8x10^{-8}m)$ and 15,000Å $(1.5x10^{-6}m)$ respectively, cause a dimensional limit, depending on process, to how close the edge of the field oxide island which defines the split can be to the channel edge. For state of the art processes, this dimension is about 8 microns $(8x10^{-6}m)$, which corresponds to a normalized coefficient of about .016 for a channel width of 500 microns $(500x10^{-6}m)$. For coefficients equal to or less than this, resort must be had to conventional, i.e. (1+h):(1-h) split, sense electrodes, for which the split is located near the center of channel 20. Thus it is contemplated by the present invention that some coefficients may be implemented using conventional splits, the rest being implemented as first described above. The actual value of the coefficient below which one should use conventional splits is readily determined empirically.

In a preferred embodiment of the present invention, as illustrated in FIGURE 1, neutral bus 43 partially circumvents the channel area in the device. This structural feature contributes to simplified fabrication of devices in accordance with the present invention.

In operation, packets of charge are transferred down channel 20, from left to right as illustrated in FIGURE 1, under the control of clock signals $\emptyset_1$, $\emptyset_2$, $\emptyset_3$. Amplifier 40, well known per se in the art, differentially senses the charge induced in busses 41 and 42. Unlike prior art devices, the charge contributed by any given segment connected to the sense busses is proportional to $\underline{h}$, not $(1+h)$ and $(1-h)$.

There is thus provided by the present invention an improved charge transfer device wherein the common mode signal is reduced, enabling one to use simplified sensing circuitry. The reduction in common mode signal is best illustrated by segment 15, implementing a weighting coefficient of zero, wherein the entire segment is connected to neutral bus 43. In devices of the prior art, a split in segment 15 would have to be accurately located in the center of the electrode in order to achieve a charge balance between the segments. Sense electrode capacitance is reduced since the unused portion of the electrode is connected to the common bus. Quantizing errors are reduced since the length of each sense electrode is individually determined. In the prior art, a single split determines the length of two sense electrodes. Thus if one segment is too long, the other is too short, compounding the error. Unlike doubly split electrode CTD filters, the clock line which drives the non-signal bearing electrodes is located outside of the channel area rather than over the channel area. This simplifies the structure and minimizes variations in channel width required to maintain uniform charge density between the non-split storage electrodes and the split storage electrodes.

While a preferred embodiment of the present invention has been shown and described, it will be apparent to those of skill in the art that various modifications can be made within the spirit and scope of the present invention. For example, as previously noted the number of sense electrodes and the particular weighting function implemented may be varied, depending upon the impulse response desired. While a preferred embodiment of the present invention uses field oxide under the splits, such can be reduced in thickness at the expense of increasing sensitivity to mask position errors during processing.

- 1 -

CLAIMS

1. In a charge transfer device having a storage body (10), an insulating layer (11) on said body (10), a plurality of storage electrodes (13, 15 to 19) and a plurality of transfer electrodes (12, 14) arranged alternately on said insulating layer (11), and clock signal lines (C) selectively connected to said electrodes, the improvement comprising:

at least some of said storage electrodes e.g. 16, 17 containing a single split extending in the approximate direction of charge transfer to divide the storage electrode into a pair of segments; and

neutral bus means (43) connected to one segment e.g. 17, 18 from each pair, wherein not all segments are from the same side of said splits.

2. The device as set forth in claim 1 and further comprising:

a first sense bus (41) for interconnecting the remaining segments on a first side of said split; and

a second sense bus (42) for interconnecting the remaining segments on the other side of said split.

0049972

- 2 -

3. The device as set forth in claim 2 wherein said splits are arranged across the direction of charge transfer proportional to predetermined weighting coefficients.

4. The device as set forth in claim 3 wherein a storage electrode (15) is connected to said neutral bus (43), thereby providing a zero weight coefficient.

5. The device as set forth in claim 4 wherein said zero weight coefficient storage electrode (15) is not split.

6. The device as set forth in claim 1 wherein said neutral bus (43) partially circumvents the channel area (20) in said storage body.

0049972

FIG 1

Ø1

Ø2

Ø3

C

S

12 13 14 17 12 13 14 19

11

<u>10</u>

FIG 2

0049972

2/2